# EUROPEAN PATENT APPLICATION

(11) **EP 4 418 320 A1**
(43) Date of publication of application: **21.08.2024**
(21) Application number: 23191650.3
(22) Date of filing: 16.08.2023
(51) Int. Cl.: H01L 27/02, H01L 27/118, H01L 21/8238

(54) **STANDARD CELL AND IC STRUCTURE WITH TRENCH ISOLATION THROUGH ACTIVE REGIONS AND GATE ELECTRODES**

(30) Priority: 15.02.2023 US 202318169304
(71) Applicant: GlobalFoundries U.S. Inc., Malta, NY 12020 (US)
(72) Inventor: Pritchard, David Charles, Malta, 12020 (US); Mazza, James P., Saratoga Springs, 12866 (US); Jain, Navneet K., Santa Clara, 95054 (US); Yu, Hong, Malta, 12020 (US)
(74) Representative: Grünecker Patent- und Rechtsanwälte PartG mbB

(57) **Abstract**

A standard cell or integrated circuit (IC) structure includes a substrate including a first active region and a second active region. A first gate electrode is over the first active region; and a second gate electrode over the second active region. A trench isolation electrically isolates the first active region and the first gate electrode from the second active region and the second gate electrode. First ends of the first active region and the first gate electrode abut a first sidewall of the trench isolation and first ends of the second active region and the second gate electrode abut a second, opposing sidewall of the trench isolation. A conductive strap extends over an upper end of the trench isolation and electrically couples the first gate electrode and the second gate electrode.

## Description

### BACKGROUND

The present disclosure relates to integrated circuit (IC) structures and, more particularly, to a standard cell and IC structure including a trench isolation through active regions and gate electrodes.

A standard cell, or simply cell, is a group of transistors and related interconnect elements that provide a given Boolean logic function (e.g., OR, AND, XNOR, XOR, etc.) or a storage function (latch or flipflop). Cells can be coupled together to design application specific IC structures. The desired cells are selected from a cell library and are mapped into cell rows in a grid. Once mapped out, the structural design is converted into a physical layout.

Cells within a given library have a common dimension in a direction of polyconductor gates (Y-direction), which is referred to as a 'height' of the cell. Different libraries have cells having different heights. Typically, like sized cells from a given library are placed in the same row in the grid and are vertically adjacent to cell rows with cells having the same height. Cells with different cell heights are placed in physically separate standard cells. The different cells of adjacent rows mate at cell boundaries. The cells of adjacent rows may also have a power rail at a selected metal layer of the design that is placed straddling the cell boundary such the power rail structure is shared between two adjacent cell rows. The power rail is a conductive line supplying electric power (V_{dd} or ground) to the parts of the cells through other interconnect layers of the IC structure.

Cells may also have a number of active regions, i.e., doped regions within the substrate, that are spaced apart by unused space in the substrate to allow room for other structures (e.g., contacts). The reduced height of the active regions caused by the unused space reduces the transistor's drive current, power and/or performance. As technologies have scaled smaller, standard cell track heights have also scaled smaller, decreasing the total active region area available in a cell image. Active region area in standard cells is currently increased in several ways. For example, the area available for active regions may be increased by reducing power rail width, reducing signal metal width and spacing, decreasing contact size, and/or other process innovations (e.g., use of fins, gate all around technology, etc.). However, these approaches to increase area for active regions disadvantageously may cause electromigration/voltage drop (EM/IR) issues, timing degradation, design rule compliance (DRC) violations, defects and related performance issues.

### SUMMARY

All aspects, examples and features mentioned below can be combined in any technically possible way.

An aspect of the disclosure provides an integrated circuit (IC) structure, comprising: a substrate including a first active region and a second active region; a first gate electrode over the first active region; a second gate electrode over the second active region; a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and a conductive strap extending over an upper end of the first trench isolation and electrically coupling the first gate electrode and the second gate electrode.

An aspect of the disclosure provides a standard cell for an integrated circuit (IC) structure having logic arranged in a plurality of cell rows extending in a first direction, the standard cell comprising: within a cell boundary: an area defining a first active region and a second active region; a first gate electrode over the first active region; a first gate electrode over the first active region; a second gate electrode over the second active region; a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and a conductive strap extending over an upper end of the first trench isolation and electrically coupling the first gate electrode and the second gate electrode.

An aspect of the disclosure provides a method, comprising: forming a first active region having a first gate electrode thereover; forming a second active region having a second gate electrode thereover; forming a first trench isolation electrically isolating the first active region and the second active region and the first gate electrode and the second gate electrode, wherein a first end of the first active region is vertically aligned with a first end of the first gate electrode and a first end of the second active region is vertically aligned with a first end of the second gate electrode; and forming a conductive strap extending over an upper end of the first trench isolation and electrically coupling the first gate electrode and the second gate electrode.

Two or more aspects described in this disclosure, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The embodiments of this disclosure will be described in detail, with reference to the following figures, wherein like designations denote like elements, and wherein:
FIG. 1 shows a schematic top-down view of an interconnect layer of a pair of prior art standard cells;
FIG. 2 shows a schematic top-down view of a prior art IC structure including a plurality of standard cells;
FIG. 3A shows a schematic top-down view of a gate electrode layer of a standard cell according to embodiments of the disclosure;
FIG. 3B shows a schematic top-down view of an interconnect layer of a standard cell according to embodiments of the disclosure;
FIG. 3C shows a cross-sectional view of a standard cell and IC structure according to embodiments of the disclosure;
FIG. 3D shows a cross-sectional view of a standard cell and IC structure according to other embodiments of the disclosure;
FIG. 4A shows a schematic top-down view of a gate electrode layer of a standard cell according to other embodiments of the disclosure;
FIG. 4B shows a schematic top-down view of an interconnect layer of a standard cell according to other embodiments of the disclosure;
FIG. 5A shows a schematic top-down view of a gate electrode layer of a standard cell according to yet other embodiments of the disclosure; and
FIG. 5B shows a schematic top-down view of an interconnect layer of a standard cell according to yet other embodiments of the disclosure.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

In the following description, reference is made to the accompanying drawings that form a part thereof, and in which are shown by way of illustration specific illustrative embodiments in which the present teachings may be practiced. These embodiments are described in sufficient detail to enable those skilled in the art to practice the present teachings, and it is to be understood that other embodiments may be used and that changes may be made without departing from the scope of the present teachings. The following description is, therefore, merely illustrative.

It will be understood that when an element such as a layer, region, or substrate is referred to as being "on" or "over" another element, it may be directly on the other element or intervening elements may also be present. In contrast, when an element is referred to as being "directly on" or "directly over" another element, there may be no intervening elements present. It will also be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present.

Reference in the specification to "one embodiment" or "an embodiment" of the present disclosure, as well as other variations thereof, means that a particular feature, structure, characteristic, and so forth described in connection with the embodiment is included in at least one embodiment of the present disclosure. Thus, the phrases "in one embodiment" or "in an embodiment," as well as any other variations appearing in various places throughout the specification are not necessarily all referring to the same embodiment. It is to be appreciated that the use of any of the following "/," "and/or," and "at least one of," for example, in the cases of "A/B," "A and/or B" and "at least one of A and B," is intended to encompass the selection of the first listed option (A) only, or the selection of the second listed option (B) only, or the selection of both options (A and B). As a further example, in the cases of "A, B, and/or C" and "at least one of A, B, and C," such phrasing is intended to encompass the first listed option (A) only, or the selection of the second listed option (B) only, or the selection of the third listed option (C) only, or the selection of the first and the second listed options (A and B), or the selection of the first and third listed options (A and C) only, or the selection of the second and third listed options (B and C) only, or the selection of all three options (A and B and C). This may be extended, as readily apparent by one of ordinary skill in the art, for as many items listed.

Embodiments of the disclosure include a standard cell or integrated circuit (IC) structure that include a substrate including a first active region and a second active region. A first gate electrode is over the first active region; and a second gate electrode over the second active region. Active region area and height in the standard cell is increased by performing a gate cut for the trench isolation for both gate electrodes and active region, so the active region area/height can be maximized. The trench isolation electrically isolates the first active region and the first gate electrode from the second active region and the second gate electrode. First ends of the first active region and the first gate electrode abut a first sidewall of the trench isolation and first ends of the second active region and the second gate electrode abut a second, opposing sidewall of the trench isolation. A conductive strap extends over an upper end of the trench isolation and electrically couples the first gate electrode and the second gate electrode.

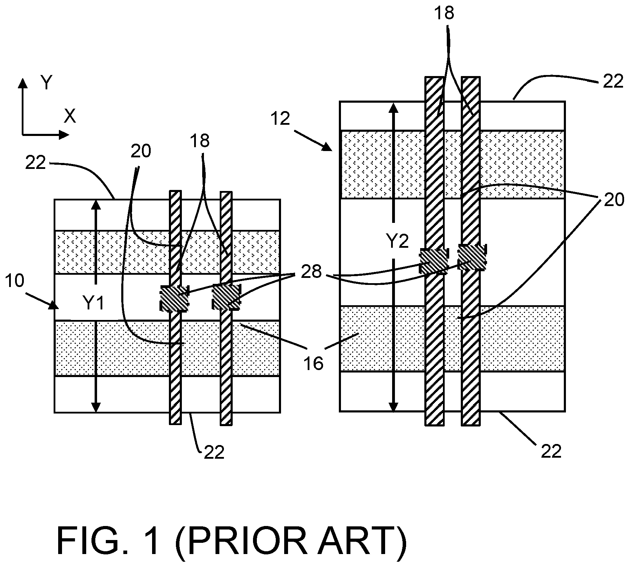

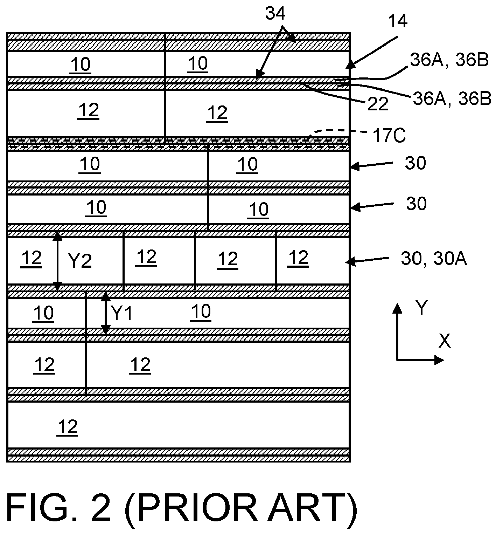

FIG. 1 shows a schematic top-down view of a device layer of a pair of prior art standard cells 10, 12 having heights Y1 and Y2 (Y1<Y2), respectively; and FIG. 2 shows a schematic top-down view of a prior art IC structure 14 including a plurality of standard cells 10, 12. A "standard cell", or simply "cell," is a group of transistors 20 and related interconnect elements that provide a given Boolean logic function (e.g., OR, AND, XNOR, XOR, etc.) or a storage function (latch or flip-flop). As shown in FIG. 2, cells 10, 12 can be coupled together to design application specific IC structures 14. FIG. 1 shows active regions 16, such as doped semiconductor regions, extending in the X-direction or width direction of cells 10, 12. (Note, a trench silicide layer used to connect active regions 16 is not shown for clarity.) Active regions 16 are illustrated as relatively large rectangular elements, but do not extend between cells 10 or 12, as illustrated. Polyconductor gate electrodes 18 (only two shown in each cell for clarity in FIG. 1) extend over any number of active regions 16 to form a plurality of transistors 20. Contacts 28 are shown to each gate electrode 18. Other structures of transistors 20 are not shown for clarity, e.g., source/drain regions, other contacts, diffusion breaks, gate cuts, etc.

Each cell 10, 12 has a height, e.g., Y1, Y2, respectively. As used herein, "height" or "cell height" indicates a dimension of the cell in a Y-direction (see legend) that is parallel to a direction of gate electrodes 18 and extends from one cell boundary 22 to another cell boundary 22. Height can also be stated as "track height." "Track" means the minimum pitch of the lowest routing metal layer, e.g., a second metal layer (M2). Track height can be stated in terms of a multiples of the track, e.g., a 6 track cell has a height 6 times the minimum pitch of the lowest routing metal layer. Generally speaking, cells 10 having a smaller height, e.g., Y1, are denser in terms of circuitry therein, have less routing space available (smaller area), and are typically lower performance, lower power. Cells 12 with a larger height typically have less dense circuitry, more routing options (larger area), and have higher power and performance.

A "cell boundary" 22 is an edge of a cell 10, 12 where electrical isolation between two rows of cells exists typically due to a gate cut and/or an active area isolation, and where the cells abut vertically or horizontally. As shown in FIG. 2, cells 10, 12 meet at a boundary, so when cells 10, 12 are joined, a common isolation area 17C (below a power rail 34 (only one shown)) is formed by the adjacent cells. As shown in FIG. 2, cells 10, 12 may be selected from "libraries" of cells having the same height, so they can be arranged in a grid together in rows 30 of common height cells. See, for example, row 30A in FIG. 2 with cells 12 of common height Y2. As shown by patterned hatching over cell boundaries 22, a power rail 34 is also defined relative to cell boundary 22 in each cell 10, 12. The power rail is a conductive line supplying electric power (V_{dd} or ground) to the parts of cells 10, 12 through other interconnect layers of IC structure 14. Power rail 34 can be at any common metal layer within cells 10, 12, e.g., middle of line metal layer, back-end-of-line metal layers, first metal layer M1, and/or higher.

As shown in FIGS. 1 and 2, conventionally, active regions 16 typically do not extend between cells, and power rails 34 are typically defined to have half portions 36A, 36B straddling across a respective cell boundary 22. It will be recognized that while half portions of power rails 36A, 36B and/or isolation regions 17C are both part of a design of any cell 10, 12, the half portion 36B or 17C shown outside cell boundary 22 is a portion of power rail 34 or isolation region formed once for two respective cells 10, 12. Half portions of power rail 36B or isolation region 17C shown outside cell boundary 22 are part of the design of the cell and schematically overlap in adjacent cells 10, 12, but are only formed once. As shown in FIG. 2, when cells 10, 12 are joined, the power rail half portions 36A, 36B and isolation region half portions collectively form power rail 34 or isolation region 17C between adjacent cells 10 or 12 in a lengthwise symmetrical manner across mating cell boundaries 22 of adjacent cells 10, 12.

To place cells 10, 12 easily in the grid shown in FIG. 2, each cell 10, 12, includes its own respective active region(s) 16 (FIG. 1) within its cell boundary 22. As noted, as technologies have scaled smaller, standard cell track heights have also scaled smaller, decreasing the total active region 16 area available in a cell image. As noted, current approaches to increase area for active regions 16 disadvantageously result in electromigration/voltage drop (EM/IR) issues, timing degradation, design rule compliance (DRC) violations, defects and related performance issues.

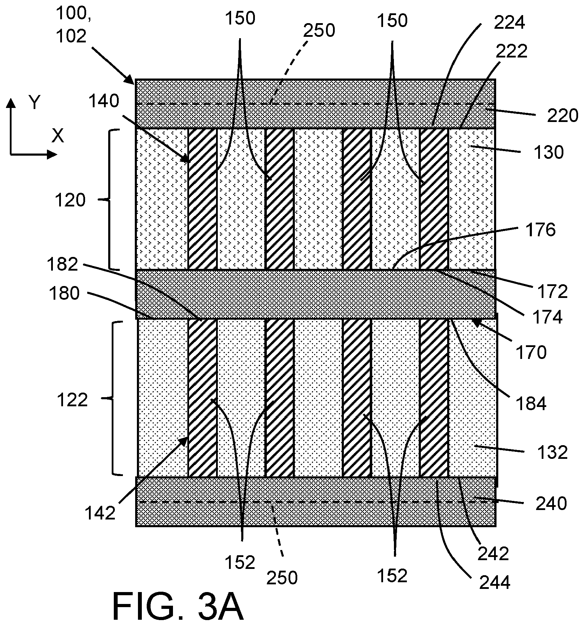

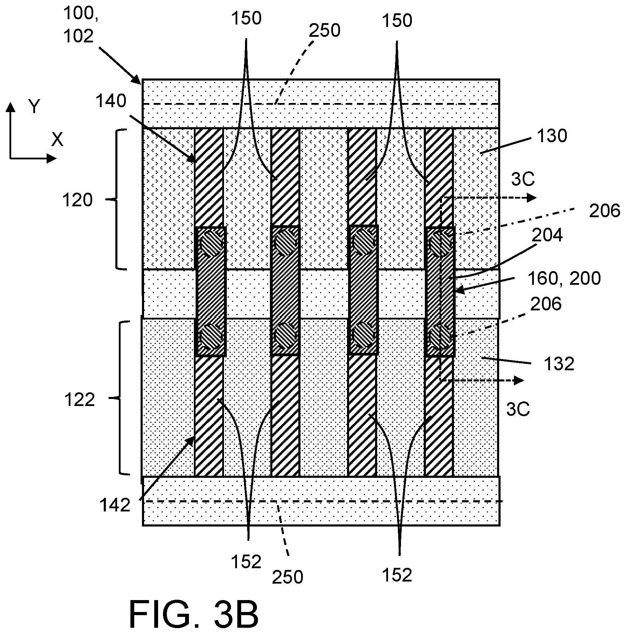

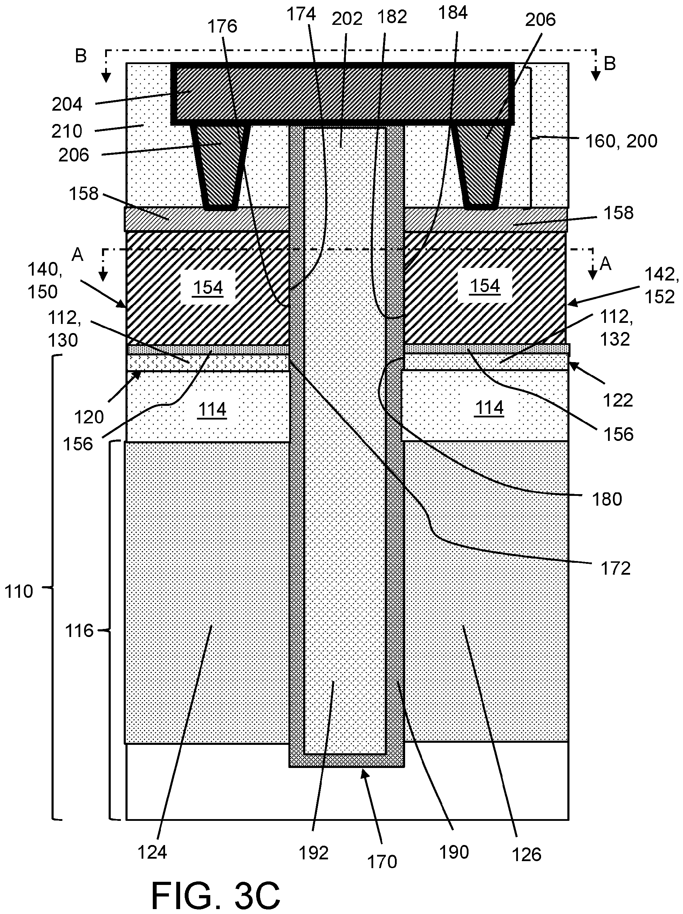

FIGS. 3A-C show embodiments of a standard cell 100 and integrated circuit (IC) structure 102, according to embodiments of the disclosure. For purposes of description, cell 100 is mainly referenced. FIG. 3A shows a schematic top-down view of cell 100 (along view line A-A in FIG. 3C), FIG. 3B shows a schematic top-down view of cell 100 at a higher level than FIG. 3A (along view line B-B in FIG. 3C), and FIG. 3C shows a cross-sectional view along view line 3C-3C in FIG. 3B. Similar to FIG. 2, standard cell 100 (hereafter "cell 100") may be provided with other cells to form IC structure 102 in which logic of cells 100 are arranged in a plurality of cell rows as in extending in a first direction. Cell 100 may include the structure described herein within a cell boundary 250 thereof.

As shown in FIG. 3C, cell 100 includes a substrate 110 including a first active region 120 and a second active region 122 therein. Substrate 110 may include a bulk substrate or as shown in FIG. 3C, a semiconductor-on-insulator (SOI) substrate, such as fully depleted SOI substrate. SOI substrates include a layered semiconductor-insulator-semiconductor substrate in place of a more conventional silicon substrate (bulk substrate). SOI substrate 110 includes a semiconductor-on-insulator (SOI) layer 112 over a buried insulator layer 114 over a base semiconductor layer 116. SOI layer 112 and base semiconductor layer 116 may include a semiconductor material, which refers to a material whose conducting properties can be altered by doping with an impurity, e.g., to create active regions 120, 122. Semiconductor materials include, for example, silicon-based semiconductor materials (e.g., silicon, silicon germanium, silicon germanium carbide, silicon carbide, etc.) and III-V compound semiconductors (i.e., compounds obtained by combining group III elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor.

A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group III dopant, such as boron (B) or indium (In), to achieve P-type conductivity, whereas a silicon-based semiconductor material is typically doped a Group V dopant, such as arsenic (As), phosphorous (P) or antimony (Sb), to achieve N-type conductivity. Active regions 120, 122 may include such dopants. Those skilled in the art will also recognize that different conductivity levels will depend upon the relative concentration levels of the dopant(s) in a given semiconductor region. Furthermore, when a semiconductor region or layer is described as being at a higher conductivity level than another semiconductor region or layer, it is more conductive (less resistive) than the other semiconductor region or layer; whereas, when a semiconductor region or layer is described as being at a lower conductivity level than another semiconductor region or layer, it is less conductive (more resistive) than that other semiconductor region or layer. Buried insulator layer 114 may include any appropriate dielectric such as but not limited to silicon dioxide, i.e., forming a buried oxide (BOX) layer. A portion of or the entire semiconductor substrate may be strained. The precise thickness of buried insulating layer 114 and SOI layer 112 may vary widely with the intended application.

FD-SOI is a planar process technology that uses an ultra-thin buried insulator layer 114 on top of base semiconductor layer 116, and a very thin SOI layer 112 over buried insulator layer 114 that provides the transistor channel. The ultra-thin SOI layer 104 does not need to be doped to create the channel, thus making the transistor "fully depleted." FD-SOI provides better transistor electrostatic characteristics compared to bulk semiconductor technology. Buried insulator layer 114 lowers the parasitic capacitance between the drain and source and confines the electrons flowing from the source to the drain, reducing leakage currents that would otherwise impede performance.

As shown in FIG. 3C, base semiconductor layer 116 may include any type of doped well 124, 126 in substrate 110 and any form of source/drain region 130, 132 over doped wells 124, 126 (shown without epitaxial raised source/drain regions). Doped wells 124, 126 and active regions 120, 122 may be formed using any now known or later developed doping process (not one of active regions 120, 122 may be undoped). Doping is the process of introducing impurities (dopants) into semiconductor material, e.g., base semiconductor layer 116 or SOI layer 112, or elements formed on the semiconductor substrate, and is often performed with a mask (or previously formed, elements in place) so that only certain areas of the substrate will be doped. For example, doping is used to form the source and drain regions 130, 132 of transistor 140, 142. An ion implanter is typically employed for the actual implantation. An inert carrier gas such as nitrogen is usually used to bring in the impurity source (dopant). Doped wells 124, 126 and source/drain (S/D) regions 130, 132 may include any appropriate dopants for the polarity of transistor 140, 142 desired. For example, first active region 120 may include a p-type dopant to create a p-type field effect transistor (FET) with the at least one first gate electrode 150, and second active region 122 may include an n-type dopant to create an n-type FET with second gate electrode 152. In another example, active region 120 (or S/D region 130) is shown doped for a pFET, e.g., with germanium, and active region 122 (or S/D region 132) is shown undoped for an nFET.

Cell 100 also includes a first gate electrode 150 over first active region 120, and a second gate electrode 152 over second active region 122. Each gate electrode 150, 152 may include any now known or later developed polyconductor 154 typically used for a gate electrode such as but not limited to a doped polysilicon, or layered metal gate materials such a work function metal layer and a gate conductor layer (not shown separately). Gate electrodes 150, 152 may be formed using any now known or later developed techniques. For example, gate electrodes 150, 152 may be formed by forming openings in a dielectric layer (not shown) depositing the various layers (e.g., gate dielectric layer, polyconductor layer(s)) thereof, and planarizing to remove any unwanted portions thereof. As shown in FIG. 3C, gate electrodes 150, 152 may also include any desired silicide layer 158 thereon to increase conductivity of interconnects 160 thereto. Silicide layer 158 may be formed using any now known or later developed techniques, e.g., depositing a metal (e.g., cobalt, nickel, titanium, among others), annealing to form the silicide, and then removing excess metal. As shown in FIGS. 3A-3B, first gate electrode 150 may include a plurality of first gate electrodes 150 over first active region 120, creating a plurality of transistors 140 (only one labeled in FIGS. 3A-3B), and second gate electrode 152 may include a plurality of second gate electrodes 152 over second active region 122, creating a plurality of transistors 142 (only one labeled in FIGS. 3A-3B).

As shown in FIG. 3A and 3C, cell 100 also includes a first trench isolation 170 electrically isolating first active region 120 and first gate electrode 150 from second active region 122 and second gate electrode 152. As shown in FIG. 3C, first trench isolation 170 extends into base semiconductor layer 116 below doped wells 124, 126. In contrast to typical trench isolations, first ends 172, 174 of first active region 122 and first gate electrode 150, respectively, abut a first sidewall 176 of first trench isolation 170. Similarly, first ends 180, 182 of second active region 122 and second gate electrode 152, respectively, abut a second, opposing sidewall 184 of trench isolation 170 from first sidewall 174. More particularly, first end 172 of first active region 120 may be vertically aligned with first end 174 of first gate electrode 150 against first sidewall 176 of trench isolation 170, and first end 180 of second active region 122 may be vertically aligned with first end 182 of second gate electrode 152 against second, opposite side 184 of trench isolation 170.

Trench isolation 170 may include any now known or later developed trench isolation structure, e.g., a deep trench isolation. Conventionally, trench isolations are formed in substrate 110 prior to gate electrode 150, 152 formation and before silicide layer 158 formation. In contrast, according to embodiments of the disclosure, trench isolation 170 formation occurs later in the processing than conventional. For example, a trench for trench isolation 170 may be etched into substrate 110, through active regions 120, 122, gate electrodes 150, 152 and silicide layer 158. As noted, one or more transistors 140, 142 of a given polarity may be disposed within an area isolated by trench isolation 170. In the example, trench isolation 170 includes a dielectric liner 190 and a dielectric body 192. The trench for trench isolation 170 can be formed using any now known or later developed technique. The trench can then be filled with insulating material(s) to isolate one region of the substrate from an adjacent region of the substrate. For example, dielectric liner 190 may include atomic layer deposited (ALD) oxide or nitride. Dielectric body 192 of each trench isolation 170 may be formed of any currently known or later developed substance capable of use in a high aspect ratio process (HARP). Dielectric body 192 may include but is not limited to: HARP oxide such as tetraethyl orthosilicate, Si(OC₂H₅)₄ (TEOS) based silicon oxide, fluorinated oxide, or high density plasma (HDP) oxide. As noted and as illustrated in FIG. 3C, trench isolation 170 may be formed after active region 120, 122 formations, after gate electrode 150, 152 formation, and perhaps (as shown) after silicide layer 158 formation. As a result, trench isolation 170 cuts through each layer. In this manner, active region 120, 122 size can be maximized within a given amount of available space.

Cell 100 may also include a conductive strap 200 extending over an upper end 202 of trench isolation 170 and electrically coupling first gate electrode 150 and second gate electrode 152. In one embodiment, shown in FIG. 3C, conductive strap 200 may include a metal wire 204 coupled to silicide layer 158 by contacts 206 on opposing sides of trench isolation 170. Metal wire 204 and/or contacts 206 may be positioned any interlayer dielectric (ILD) layer 210 formed over silicide layer 158. ILD layer 210 may include any appropriate ILD material such as but not limited to carbon-doped silicon dioxide materials; fluorinated silicate glass (FSG); organic polymeric thermoset materials; silicon oxycarbide; SiCOH dielectrics; fluorine doped silicon oxide; spin-on glasses; silsesquioxanes, including hydrogen silsesquioxane (HSQ), methyl silsesquioxane (MSQ) and mixtures or copolymers of HSQ and MSQ; benzocyclobutene (BCB)-based polymer dielectrics, and any silicon-containing low-k dielectric. Conductive strap 200 may be formed using any now known or later developed technique, e.g., damascene or dual damascene processing. In one non-limiting example, contacts 206 may be formed by patterning a mask, etching contact openings to silicide layer 158, and forming a conductor in the openings. The conductor may include, for example, a refractory metal liner and a contact metal. The refractory metal liner (not labeled for clarity) may include, for example, ruthenium (Ru), tantalum (Ta), titanium (Ti), tungsten (W), iridium (Ir), rhodium (Rh) and platinum (Pt), etc., or mixtures of thereof. The contact metal may include any now known or later developed contact metal such as but not limited to copper (Cu) or tungsten (W). Metal wire 204 may be formed simultaneously with contacts 206, or afterwards - after an additional amount of ILD layer 210 is formed.

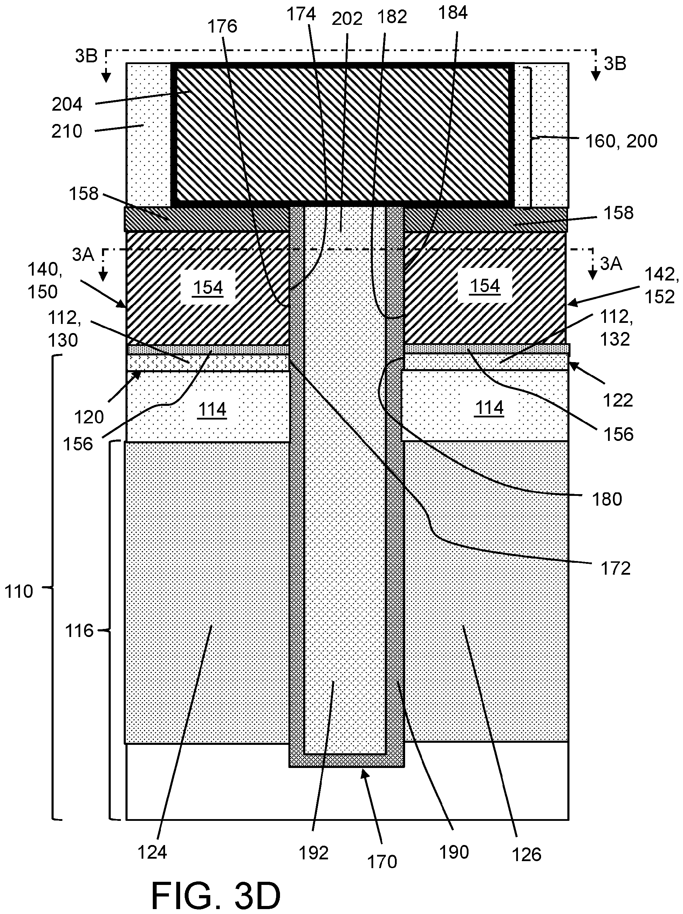

FIG. 3D shows a cross-sectional view of cell 100 according to other embodiments of the disclosure. FIG. 3D is substantially similar to FIG. 3C, except contacts 206 are omitted and metal wire 204 lands directly on silicide layer 158. Here a bottom surface of metal wire 204, and upper surfaces of trench isolation 170 and silicide layer 158 may be coplanar.

Referring to FIG. 3A, cell 100 may further include a second trench isolation 220 at second ends 222, 224 of first active region 120 and first gate electrode 150, respectively, opposite first ends 172, 174 thereof. Cell 100 may further include a third trench isolation 240 at third ends 242, 244 of first active region 120 and first gate electrode 150, respectively, opposite first ends 182, 184 thereof. Trench isolations 220, 240 may be formed substantially similarly to trench isolation 170. Trench isolations 220, 240 may include a portion thereof (see dashed line) outside of cell boundary 250 for mating with another row of cells - see FIG. 2. That is, a portion of second or third trench isolation 220, 240 may extend beyond cell boundary 250 for mating with an adjacent cell 100.

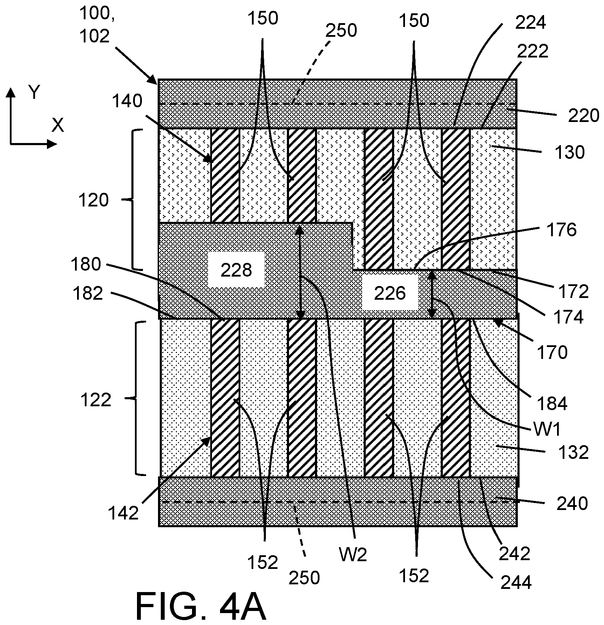

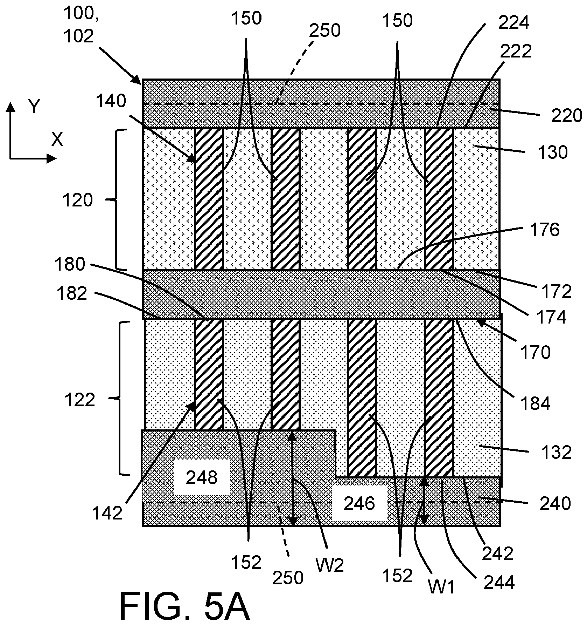

FIGS. 4A and 5A show schematic top-down views of cells 100 and IC structures 102, according to other embodiments of the disclosure. As shown in FIGS. 4A and 5A, at least one of first trench isolation 170 and third trench isolation 240 may have a first portion 226, 246, respectively, having a first width W1 and a second portion 228, 248 having a second width W2 greater than first width W1. It is noted that second trench isolation 220 in FIGS. 3A-3B could similarly include portions of different widths. The different trench isolations can be formed by patterning a larger opening for the larger portions and etching appropriately. The different width portions allow optimization of active regions 120, 122.

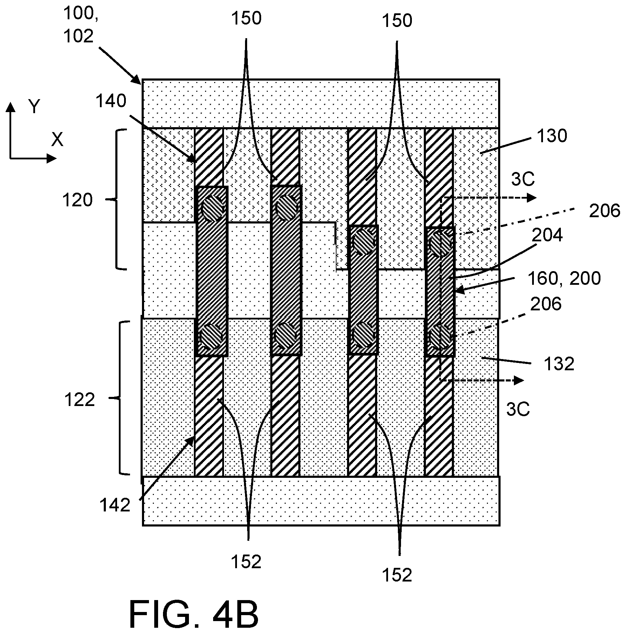

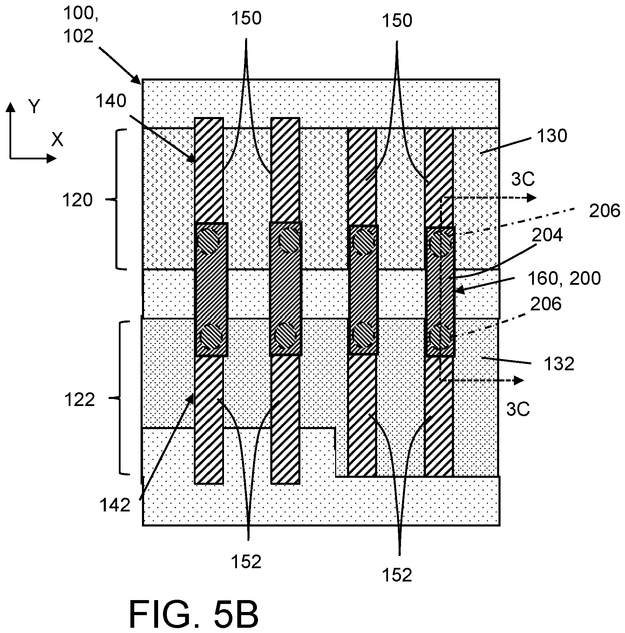

FIGS. 4B and 5B show schematic top-down views of IC structures 102 including the trench isolations of FIGS. 4A and 5A. As illustrated, first trench isolation 170 has first portion 226 having first width W1 separating at least one of plurality of first gate electrodes 150 from at least one of plurality of second gate electrodes 152, and second portion 228 having second width W2 greater than first width W1 separating at least one of plurality of first gate electrodes 150 from at least one of plurality of second gate electrodes 152. The transistors 140, 142 formed with first portion 226 of trench isolation 170 adjacent thereto will have different characteristics than transistors 140, 142 formed with second portion 228 of trench isolation 170 adjacent thereto. For example, the width of the device may be altered to modulate the transistor characteristics of the drive current based on circuit design schematics.

A method according to embodiments of the disclosure may include forming first active region 120 having first gate electrode 150 thereover, and forming second active region 122 having second gate electrode 152 thereover. The formation steps were previously described herein.

The method may also include forming trench isolation 170 to electrically isolate first active region 120 and second active region 122 and first gate electrode 150 and second gate electrode 152. First end 172 of first active region 120 is vertically aligned with first end 174 of first gate electrode 150 and first end 180 of second active region 122 is vertically aligned with first end 182 of second gate electrode 152. More particularly, first end 172 of first active region 120 may be vertically aligned with first end 174 of first gate electrode 150 against first sidewall 176 of trench isolation 170, and first end 180 of second active region 122 may be vertically aligned with first end 182 of second gate electrode 152 against second, opposite side 184 of trench isolation 170.

The method may also include forming second trench isolation 220 at second ends 222, 224 of first active region 120 and first gate electrode 150 opposite first ends 172, 174 thereof. As noted, a portion of second trench isolation 220 may extend beyond cell boundary 250 for mating with an adjacent cell 100. The method may also include forming a third trench isolation 240 at another end 242 of second active region 122 and second gate electrode 152 opposite first ends 180, 182 thereof. As noted, a portion of third trench isolation 240 may extend beyond cell boundary 250 for mating with an adjacent cell 100. At least one of first trench isolation 170 and third trench isolation 240 may have first portion 226, 246 having first width W1 and second portion 228, 248 having second width W2 greater than first width W1, respectively.

As noted, active regions 120, 122 and gate electrodes 150, 152 are formed before trench isolation(s) 170, 220, 240. Silicide layer 158 may also be formed before trench isolation 170.

The method may also include forming conductive strap 200 extending over upper end 202 of trench isolation 170 and electrically coupling first gate electrode 150 and second gate electrode 152. The formation steps were previously described herein.

Embodiments of the disclosure provide various technical and commercial advantages, examples of which are discussed herein. Cell 100 and IC structure 102 with an active region trench isolation 170 cut applied post gate electrode 150, 152 formation to reduce the active region 120 to active region 122 distance required. Trench isolation 170 thus allows active region optimization for different transistor characteristics. The cell and IC structure do not require metal width and/or contact size or number reduction as would normally be required. In certain examples, active regions 130, 132 can be increased in size in the Y direction by almost 25%.

The structure and method as described above are used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher-level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. "Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately" and "substantially", are not to be limited to the precise value specified. In at least some instances, the approximating language may correspond to the precision of an instrument for measuring the value. Here and throughout the specification and claims, range limitations may be combined and/or interchanged, such ranges are identified and include all the sub-ranges contained therein unless context or language indicates otherwise. "Approximately" as applied to a particular value of a range applies to both values, and unless otherwise dependent on the precision of the instrument measuring the value, may indicate +/-10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application, and to enable others of ordinary skill in the art to understand the disclosure for various embodiments with various modifications as are suited to the particular use contemplated.

In summary, the following embodiments are explicitly disclosed.

### Embodiment 1:

An integrated circuit (IC) structure, comprising: a substrate including a first active region and a second active region; a first gate electrode over the first active region; a second gate electrode over the second active region; a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and a conductive strap extending over an upper end of the first trench isolation and electrically coupling the first gate electrode and the second gate electrode.

### Embodiment 2:

An integrated circuit (IC) structure, comprising: a first gate electrode over a first active region of the IC structure; a second gate electrode over a second active region of the IC structure; a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and a conductive strap extending over an upper end of the first trench isolation and electrically coupling the first gate electrode and the second gate electrode. The IC structure may comprise a substrate and the substrate may comprise the first active region and the second active region.

### Embodiment 3:

The IC structure of embodiment 1 or 2, wherein the first end of the first active region is vertically aligned with the first end of the first gate electrode against the first sidewall of the first trench isolation, and the first end of the second active region is vertically aligned with the first end of the second gate electrode against the second, opposite side of the first trench isolation.

### Embodiment 4:

The IC structure of one of embodiments 1 to 3, further comprising a second trench isolation at a second end of the first active region and the first gate electrode opposite the first ends thereof.

### Embodiment 5:

The IC structure of embodiment 4, further comprising a third trench isolation at a second end of the second active region and the second gate electrode opposite the first ends thereof.

### Embodiment 6:

The IC structure of embodiment 5, wherein at least one of the first trench isolation and the third trench isolation has a first portion having a first width and a second portion having a second width greater than the first width.

### Embodiment 7:

The IC structure of one of embodiments 1 to 6, wherein the first active region includes an n-type dopant to create an n-type field effect transistor with the first gate electrode, and the second active region include a p-type dopant to create a p-type field effect transistor with the second gate electrode.

### Embodiment 8:

The IC structure of one of embodiments 1 to 7, wherein the first gate electrode includes a plurality of first gate electrodes over the first active region, and the second gate electrode includes a plurality of second gate electrodes over the second active region, and wherein the first trench isolation has a first portion having a first width separating at least one of the plurality of first gate electrodes from at least one of the plurality of second gate electrodes, and a second portion having a second width greater than the first width separating at least one of the plurality of first gate electrodes from at least one of the plurality of second gate electrodes.

### Embodiment 9:

A standard cell of the integrated circuit (IC) structure of one of embodiments 1 to 8, the IC structure having logic arranged in a plurality of cell rows extending in a first direction, the standard cell comprising within a cell boundary of the standard cell an area defining the first active region and the second active region with the first gate electrode over the first active region and the second gate electrode over the second active region, the first trench isolation electrically isolating the first active region and the first gate electrode from the second active region and the second gate electrode, and the conductive strap extending over the upper end of the first trench isolation. The area may be provided within the substrate of the IC structure.

### Embodiment 10:

A standard cell for an integrated circuit (IC) structure having logic arranged in a plurality of cell rows extending in a first direction, the standard cell comprising: within a cell boundary: an area defining a first active region and a second active region; a first gate electrode over the first active region; a first gate electrode over the first active region; a second gate electrode over the second active region; a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and a conductive strap extending over an upper end of the first trench isolation and electrically coupling the first gate electrode and the second gate electrode.

### Embodiment 11:

The standard cell of embodiment 9 or 10, wherein the first end of the first active region is vertically aligned with the first end of the first gate electrode against the first sidewall of the first trench isolation, and the first end of the second active region is vertically aligned with the first end of the second gate electrode against the second, opposite side of the first trench isolation.

### Embodiment 12:

The standard cell of one of embodiments 9 to 11, further comprising a second trench isolation at a second end of the first active region and the first gate electrode opposite the first ends thereof, wherein a portion of the second trench isolation extends beyond the cell boundary.

### Embodiment 13:

The standard cell of embodiment 12, further comprising a third trench isolation at a second end of the second active region and the second gate electrode opposite the first ends thereof, wherein a portion of the third trench isolation extends beyond the cell boundary.

### Embodiment 14:

The standard cell of embodiment 13, wherein at least one of the first trench isolation and the third trench isolation has a first portion having a first width and a second portion having a second width greater than the first width.

### Embodiment 15:

The standard cell of one of embodiments 9 to 14, wherein the first active region includes an n-type dopant to create an n-type field effect transistor with the first gate electrode, and the second active region include a p-type dopant to create a p-type field effect transistor with the second gate electrode.

### Embodiment 16:

The standard cell of one of embodiments 9 to 15, wherein the first gate electrode includes a plurality of first gate electrodes over the first active region, and the second gate electrode includes a plurality of second gate electrodes over the second active region, and wherein the first trench isolation has a first portion having a first width separating at least one of the plurality of first gate electrodes from at least one of the plurality of second gate electrodes, and a second portion having a second width greater than the first width separating at least one of the plurality of first gate electrodes from at least one of the plurality of second gate electrodes.

### Embodiment 17:

A method, comprising: forming a first active region having a first gate electrode thereover; forming a second active region having a second gate electrode thereover; forming a first trench isolation electrically isolating the first active region and the second active region and the first gate electrode and the second gate electrode, wherein a first end of the first active region is vertically aligned with a first end of the first gate electrode and a first end of the second active region is vertically aligned with a first end of the second gate electrode; and forming a conductive strap extending over an upper end of the first trench isolation and electrically coupling the first gate electrode and the second gate electrode.

### Embodiment 18:

The method of embodiment 17, wherein the first end of the first active region is vertically aligned with the first end of the first gate electrode against the first sidewall of the first trench isolation, and the first end of the second active region is vertically aligned with the first end of the second gate electrode against the second, opposite side of the first trench isolation.

### Embodiment 19:

The method of embodiment 17 or 18, further comprising forming a second trench isolation at a second end of the first active region and the first gate electrode opposite the first ends thereof, wherein a portion of the second trench isolation extends beyond the cell boundary.

### Embodiment 20:

The method of embodiment 19, further comprising forming a third trench isolation at a second end of the second active region and the second gate electrode opposite the first ends thereof, wherein a portion of the third trench isolation extends beyond the cell boundary.

### Embodiment 21:

The method of embodiment 20, wherein at least one of the second trench isolation and the third trench isolation has a first portion having a first width and a second portion having a second width greater than the first width.

### Embodiment 22:

The method of one of embodiments 17 to 21, wherein the first active region includes an n-type dopant to create an n-type field effect transistor with the at least one first gate electrode, and the second active region include a p-type dopant to create a p-type field effect transistor with the second gate electrode.

### Embodiment 23:

The method of one of embodiments 17 to 22, wherein the IC structure of one of embodiments 1 to 8 is formed.

### Embodiment 24:

The method of one of embodiments 17 to 22, wherein the standard cell of one of embodiments 9 to 16 is formed.

At least in the embodiments above, the term "include" and its variants may be interpreted as meaning that an embodiment includes stated features, while not necessarily excluding the presence of other features that are not explicitly stated.

## Claims

1. An integrated circuit (IC) structure, comprising:
a first gate electrode over a first active region;
a second gate electrode over a second active region;
a first trench isolation electrically isolating the first active region and the first gate electrode from the second active region and the second gate electrode, wherein first ends of the first active region and the first gate electrode abut a first sidewall of the first trench isolation and first ends of the second active region and the second gate electrode abut a second, opposing sidewall of the first trench isolation; and
a conductive strap extending over an upper end of the first trench isolation and electrically coupling the first gate electrode and the second gate electrode.

2. The IC structure of claim 1, wherein the first end of the first active region is vertically aligned with the first end of the first gate electrode against the first sidewall of the first trench isolation, and the first end of the second active region is vertically aligned with the first end of the second gate electrode against the second, opposite side of the first trench isolation.

3. The IC structure of claim 1 or 2, further comprising a second trench isolation at a second end of the first active region and the first gate electrode opposite the first ends thereof.

4. The IC structure of claim 3, further comprising a third trench isolation at a second end of the second active region and the second gate electrode opposite the first ends thereof, wherein at least one of the first trench isolation and the third trench isolation preferably has a first portion having a first width and a second portion having a second width greater than the first width.

5. The IC structure of one of claims 1 to 4, wherein the first active region includes an n-type dopant to create an n-type field effect transistor with the first gate electrode, and the second active region include a p-type dopant to create a p-type field effect transistor with the second gate electrode.

6. The IC structure of one of claims 1 to 5, wherein the first gate electrode includes a plurality of first gate electrodes over the first active region, and the second gate electrode includes a plurality of second gate electrodes over the second active region, and
wherein the first trench isolation has a first portion having a first width separating at least one of the plurality of first gate electrodes from at least one of the plurality of second gate electrodes, and a second portion having a second width greater than the first width separating at least one of the plurality of first gate electrodes from at least one of the plurality of second gate electrodes.

7. A standard cell of the integrated circuit (IC) structure of one of claims 1 to 6, the IC structure having logic arranged in a plurality of cell rows extending in a first direction, the standard cell comprising within a cell boundary of the standard cell an area defining the first active region and the second active region with the first gate electrode over the first active region and the second gate electrode over the second active region, the first trench isolation electrically isolating the first active region and the first gate electrode from the second active region and the second gate electrode, and the conductive strap extending over the upper end of the first trench isolation.

8. The standard cell of claim 7 in combination with the IC structure of claim 3, wherein a portion of the second trench isolation extends beyond the cell boundary.

9. The standard cell of claim 8 in combination with the IC structure of claim 4, wherein a portion of the third trench isolation extends beyond the cell boundary.

10. A method, comprising:
forming a first active region having a first gate electrode thereover;
forming a second active region having a second gate electrode thereover;
forming a first trench isolation electrically isolating the first active region and the second active region and the first gate electrode and the second gate electrode, wherein a first end of the first active region is vertically aligned with a first end of the first gate electrode and a first end of the second active region is vertically aligned with a first end of the second gate electrode; and
forming a conductive strap extending over an upper end of the first trench isolation and electrically coupling the first gate electrode and the second gate electrode.

11. The method of claim 10, wherein the first end of the first active region is vertically aligned with the first end of the first gate electrode against the first sidewall of the first trench isolation, and the first end of the second active region is vertically aligned with the first end of the second gate electrode against the second, opposite side of the first trench isolation.

12. The method of claim 10 or 11, further comprising forming a second trench isolation at a second end of the first active region and the first gate electrode opposite the first ends thereof, wherein a portion of the second trench isolation extends beyond the cell boundary.

13. The method of claim 12, further comprising forming a third trench isolation at a second end of the second active region and the second gate electrode opposite the first ends thereof, wherein a portion of the third trench isolation extends beyond the cell boundary.

14. The method of claim 13, wherein at least one of the second trench isolation and the third trench isolation has a first portion having a first width and a second portion having a second width greater than the first width.

15. The method of one of claims 10 to 14, wherein the first active region includes an n-type dopant to create an n-type field effect transistor with the at least one first gate electrode, and the second active region include a p-type dopant to create a p-type field effect transistor with the second gate electrode.
